# EUROPÄISCHE PATENTSCHRIFT

(11) **EP 2 352 907 B1**
(45) Veröffentlichungstag und Bekanntmachung des Hinweises auf die Patenterteilung: **04.03.2015**
(21) Anmeldenummer: 09771682.3
(22) Anmeldetag: 09.11.2009
(51) Int. Cl.: F01D 5/28, C23C 30/00

(54) **EROSIONSSCHUTZSCHICHT FÜR AERODYNAMISCHE KOMPONENTEN UND STRUKTUREN UND VERFAHREN ZU IHRER HERSTELLUNG**
ANTI-EROSION LAYER FOR AERODYNAMIC COMPONENTS AND STRUCTURES AND METHOD FOR THE PRODUCTION THEREOF
COUCHE DE PROTECTION CONTRE L'ÉROSION POUR DES COMPOSANTS ET DES STRUCTURES AÉRODYNAMIQUES, ET PROCÉDÉ DE PRODUCTION

(30) Priorität: 10.11.2008 DE 102008056578
(43) Veröffentlichungstag der Anmeldung: 10.08.2011
(73) Patentinhaber: Airbus Operations GmbH, 21129 Hamburg (DE)
(72) Erfinder: BAYER, Erwin, 85221 Dachau (DE); STEINWANDEL, Jürgen, 88690 Uhldingen-Mühlhofen (DE)
(74) Vertreter: Kopf, Korbinian Paul
(86) Internationale Anmeldenummer: PCT/DE2009/001560
(87) Internationale Veröffentlichungsnummer: WO 2010/051803

(56) Entgegenhaltungen:
- EP-A1- 1 927 670
- EP-A2- 1 647 612
- DE-A1-102007 031 932

## Beschreibung

Die Erfindung betrifft eine Erosionsschutzschicht für aerodynamische Komponenten und Strukturen, sowie ein Verfahren zur Herstellung einer solchen.

Aerodynamische Komponenten und Strukturen, wie beispielsweise Verdichterbeschaufelungen von Triebwerken, Fan- oder Propellerblätter, Hubschrauberrotoren, Flügelvorderkanten, etc., unterliegen in Abhängigkeit von ihrem Einsatzprofil, dem an ihnen auftretenden aerodynamischen Lasten, sowie der verwendeten spezifischen Werkstoffe, insbesondere bei Faserverbundwerkstoffen, einem Verschleiß durch strömungsgetragene Partikel, wie Wasser, Staub, gröbere Partikel, etc. Eine solche Erosion von Strömungsprofilen führt zu Abweichungen und Zerstörung der Profiltreue, verbunden mit erhöhtem Strömungswiderstand und verschlechterter aerodynamischer Wirksamkeit. Darüber hinaus kann das Material der aerodynamischen Komponenten oder Strukturen durch Rissbildung degradiert werden. Dem Erosionsschutz dienende Beschichtungen auf solchen Bauteilen können diese Art von Alterung erheblich verzögern. Bisher wurden Beschichtungssysteme mit einer alternierenden Folge von harten und weichen Schichten für den Erosionsschutz von aerodynamischen Komponenten und Strukturen verwendet. EP 1 647 612, EP 1 927 670, DE 102007031932 beschreiben Erosionsschutzschichten nach dem Oberbegriff des Anspruchs 1.

Die Aufgabe der Erfindung ist es, eine Erosionsschutzschicht für aerodynamische Komponenten und Strukturen zu schaffen, die eine hohe Wirksamkeit und Beständigkeit hat und die mit geringem Aufwand herzustellen ist. Weiterhin soll ein Verfahren zur Herstellung einer solchen Erosionsschutzschicht angegeben werden.

Die Erfindung wird durch eine Erosionsschutzschicht für aerodynamische Komponenten und Strukturen mit den Merkmalen des Anspruchs 1 gelöst. Weiterhin wird die Aufgabe gelöst durch ein Verfahren zur Herstellung einer Erosionsschutzschicht gemäß Anspruch 13 sowie gemäß Anspruch 14. Vorteilhafte Ausführungsformen und Weiterbildungen der Erfindung sind in den jeweiligen Unteransprüchen angegeben.

Durch die Erfindung wird eine Erosionsschutzschicht für aerodynamische Komponenten und Strukturen geschaffen, bei der in einer Bindeschicht aus einem auf den aerodynamischen Komponenten oder Strukturen gut haftenden Material eine Vielzahl von Hartstoffpartikeln eingelagert sind.

Die Hartstoffpartikel können überwiegend einen Durchmesser im Mikrometerbereich haben.

Die Hartstoffpartikel können überwiegend einen Durchmesser im Nanometerbereich haben.

Die Hartstoffpartikel können überwiegend einen Durchmesser kleiner als 200 µm haben.

Die Hartstoffpartikel können überwiegend einen Durchmesser zwischen 8 µm und 80 µm haben.

Die Hartstoffpartikel können überwiegend einen Durchmesser zwischen 0,8 µm und 8 µm haben.

Die Hartstoffpartikel können überwiegend einen Durchmesser zwischen 80 nm und 800 nm haben.

Die Hartstoffpartikel können überwiegend einen Durchmesser zwischen 8 nm und 80 nm haben.

Die Hartstoffpartikel können überwiegend einen Durchmesser von weniger als 8 nm haben.

Gemäß einer Ausführungsform der Erfindung haben die Hartstoffpartikel überwiegend den gleichen Durchmesser.

Gemäß einer anderen Ausführungsform der Erfindung haben die Hartstoffpartikel unterschiedliche Durchmesser. Die Hartstoffpartikel können unterschiedliche Durchmesser aus einem oder mehreren der oben genannten Bereiche oder auch Durchmesser außerhalb dieser Bereiche haben.

Die Hartstoffpartikel können aus einem oder mehreren der Materialien enthaltend Keramik, kubisches Bornitrid (CBM), Silikate, Carbide oder (andere) Nitride oder diamantartige Kohlenstoffpartikel bestehen.

Die Bindeschicht kann metallisch, organisch oder anorganisch sein.

Gemäß einer Ausführungsform der Erfindung macht die Bindeschicht weniger als 60 Vol.-%, vorzugsweise weniger als 40 Vol.% der Erosionsschutzschicht aus.

Weiterhin wird durch die Erfindung ein Verfahren zur Herstellung einer Erosionsschutzschicht für aerodynamische Komponenten und Strukturen der genannten Art geschaffen, bei dem die Erosionsschutzschicht durch Spritzen einer Mischung eines die Bindeschicht bildenden Materials und der Hartstoffpartikel auf die aerodynamische Komponente oder Struktur aufgebracht wird.

Weiterhin wird durch die Erfindung ein Verfahren zur Herstellung einer Erosionsschutzschicht für aerodynamische Komponenten und Strukturen der vorher genannten Art geschaffen, bei dem die Erosionsschutzschicht durch Aufdampfen eines die Bindeschicht bildenden Materials auf die aerodynamische Komponente oder Struktur hergestellt wird, wobei die Hartstoffpartikel in eine Dampfwolke des die Bindeschicht bildenden Material eingebracht und zusammen mit diesem auf die aerodynamische Komponente oder Struktur aufgebracht bzw. niedergeschlagen werden.

Gemäß einer vorteilhaften Ausführungsform des erfindungsgemäßen Verfahrens wird die Erosionsschutzschicht in einem Arbeitsgang in einer gewünschten Schichtdicke auf die aerodynamische Komponente oder Struktur aufgetragen.

Im folgenden werden Ausführungsbeispiele der Erfindung anhand der Zeichnung erläutert.

Es zeigt:
**Fig. 1** eine schematisierte vergrößerte Darstellung eines Teils einer aerodynamischen Komponente oder Struktur, auf welche eine Erosionsschutzschicht gemäß einem Ausführungsbeispiel der Erfindung aufgebracht ist;
**Fig. 2** eine schematisierte Darstellung eines Verfahrens zur Herstellung einer Erosionsschutzschicht auf einer aerodynamischen Komponente oder Struktur gemäß einem Ausführungsbeispiel der Erfindung; und
**Fig. 3** eine schematisierte Darstellung eines Verfahrens zur Herstellung einer Erosionsschutzschicht auf einer aerodynamischen Komponente oder Struktur gemäß einem weiteren Ausführungsbeispiel der Erfindung.

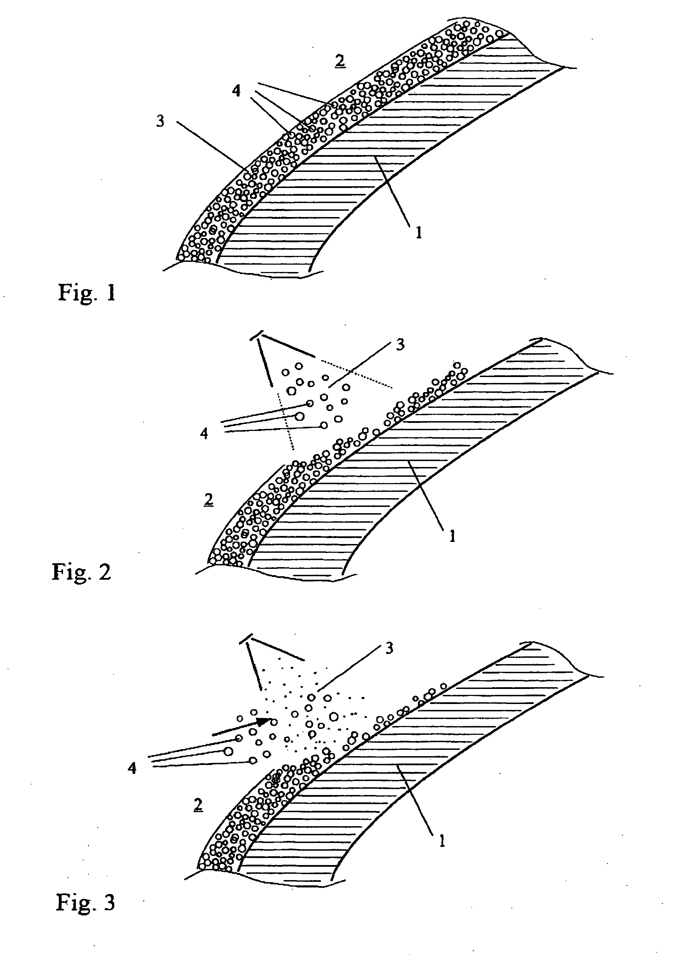

In Fig. 1 ist schematisiert und im Querschnitt ein Teil einer aerodynamischen Komponente oder Struktur 1 gezeigt, beispielsweise einer Verdichterschaufel eines Triebwerks, eines Fan- oder Propellerblattes, eines Hubschrauberrotors, einer Flügelvorderkante oder eines anderen aerodynamisch wirksamen Bauteils.

Auf der aerodynamischen Komponente 1 ist eine Erosionsschutzschicht 2 aufgebracht, welche zum Schutz vor Verschleiß durch strömungsgetragene Partikel, wie Wasser, Staub, größere Partikel, etc. vorgesehen ist. Diese Erosionsschutzschicht 2 umfaßt eine Bindeschicht 3 aus einem auf der aerodynamischen Komponente oder Struktur 1 gut haftenden Material, in welche eine Vielzahl von Hartstoffpartikeln 4 eingelagert sind. Die Hartstoffpartikel 4 sind allgemein mikro- oder nanoskalige Teilchen, die überwiegend gleichen oder ähnlichen Durchmesser oder die unterschiedliche Durchmesser haben können. Allgemein können die Hartstoffpartikel 4 einen Durchmesser von einigen wenigen Nanometern bis vielen Mikrometern haben, je nach Art und Eigenschaft sowie Belastung der zu schützenden aerodynamischen Komponente 1.

Die Hartstoffpartikel 4 können eines oder mehrere der Materialien Keramik, kubisches Bornitrid (CBM), Silikate, Carbide, sonstige Nitride oder diamantartige Kohlenstoffpartikel sein. Die Bindeschicht 3 kann metallisch, organisch oder anorganisch sein, beispielsweise eine Schicht eines geeigneten Metalls, ein organischer Lack oder ein anorganischer Kleber o.ä. Die Hartstoffpartikel 4 und die Bindeschicht 3 bilden somit ein System, bei dem die besagten mikro- oder nanoskaligen Hartstoffpartikel 4 in eine "weiche" Bindung eingelagert sind, welche durch die Bindeschicht 3 geschaffen wird. Die Bindeschicht beträgt beispielsweise unter 40 Vol.% der gesamten Erosionsschutzschicht 2.

Die Erosionsschutzschicht 2 verhält sich durch den hohen Hartstoffanteil der Partikel 4 wie eine massive harte Schicht und schützt die darunter liegende Oberfläche der Komponente oder Struktur 1. Beim Einschlag eines größeren massiven Partikels werden nur die kleinen Hartstoffpartikel 4 getroffen, ohne dass ein Riss in der Erosionsschutzschicht 2 induziert wird, aufgrund der "weichen" oder elastischen Eigenschaft der Bindeschicht 3.

Gemäß dem in Fig. 2 gezeigten Ausführungsbeispiel eines Verfahrens zur Herstellung einer solchen Erosionsschutzschicht 2 wird diese durch Spritzen einer Mischung auf die aerodynamische Komponente oder Struktur 1 aufgebracht, welche aus dem die Bindeschicht 3 bildenden Materials und den Hartstoffpartikeln 4 besteht. Das Material der Bindeschicht 3 kann ein flüssiges, spritzfähiges Material mit einer oder mehreren Komponenten sein; es kann ein Lösungsmittel und/oder andere Zusatzstoffe enthalten. Die Mischung des die Bindeschicht 3 bildenden Materials und der Hartstoffpartikel 4 wird mit einem geeigneten Spritzgerät 5 aufgetragen, wie es an sich im Stande der Technik wohlbekannt ist.

Bei dem in Fig. 3 gezeigten Ausführungsbeispiel eines erfindungsgemäßen Verfahrens zur Herstellung der Erosionsschutzschicht 2 auf der aerodynamischen Komponente oder Struktur 1 wird ein die Bindeschicht 3 bildendes Material auf die Komponente 1 aufgedampft, wobei im Zuge des Prozesses die Hartstoffpartikel 4 in die Dampfwolke des die Bindeschicht 3 bildenden Materials eingebracht und zusammen mit diesem auf der Komponente 1 niedergeschlagen werden. Die Zuführung des Materials der Bindeschicht 3 und der Hartstoffpartikel 4 erfolgt zunächst getrennt; nach Mischung derselben werden diese dann gemeinsam auf der Komponente 1 niedergeschlagen, so dass sie eine gleichmäßige, homogene Erosionsschutzschicht 2 bilden. Das Aufdampfen erfolgt mittels eines Bedampfungsgeräts 6, das in der Fig. 3 nur schematisch angedeutet und im Stande der Technik an sich bekannt ist.

Die Erosionsschutzschicht 2 wird gemäß einem Ausführungsbeispiel der Erfindung in einem Arbeitsgang in einer gewünschten Schichtdicke d aufgetragen. Die Schichtdicke d kann im Nanometerbereich liegen, sie kann im Mikrometerbereich liegen, sie kann Bruchteile eines Millimeters oder auch mehr betragen.

Gegebenenfalls kann zusätzlich noch eine Deckschicht auf der Erosionsschutzschicht 2 aufgetragen werden, beispielsweise eine solche, die für eine besondere Glattheit sorgt, oder lediglich eine solche, welche ästhetischen Zwecken dient, wie eine Bemalung.

### Bezugszeichenliste

- 1: aerodynamische Komponente oder Struktur
- 2: Erosionsschutzschicht
- 3: Bindeschicht
- 4: Hartstoffpartikel
- 5: Spritzgerät
- 6: Aufdampfgerät

## Patentansprüche

1. Erosionsschutzschicht zum Schutz vor Verschleiß durch strömungsgetragene Partikel für aerodynamische Komponenten und Strukturen, wobei die Erosionsschutzschicht der Strömung ausgesetzt ist, **dadurch gekennzeichnet, dass** in einer Bindeschicht (3) aus einem auf den aerodynamischen Komponenten oder Strukturen (1) gut haftenden Material eine Vielzahl von Hartstoffpartikeln (4) eingelagert sind; und
dass die Bindeschicht (3) weniger als 60 Vol.% der Erosionsschutzschicht (2) ausmacht.

2. Erosionsschutzschicht nach Anspruch 1, **dadurch gekennzeichnet, dass** die Hartstoffpartikel (4) einen Durchmesser im Mikrometerbereich haben.

3. Erosionsschutzschicht nach Anspruch 1, **dadurch gekennzeichnet, dass** die Hartstoffpartikel (4) einen Durchmesser im Nanometerbereich haben.

4. Erosionsschutzschicht nach Anspruch 2, **dadurch gekennzeichnet, dass** die Hartstoffpartikel (4) einen Durchmesser kleiner als 200 µm haben.

5. Erosionsschutzschicht nach Anspruch 2, **dadurch gekennzeichnet, dass** die Hartstoffpartikel (4) einen Durchmesser zwischen 8 nm und 80 µm haben, insbesondere zwischen 8 nm und 80 nm, zwischen 80 nm und 800 nm, zwischen 0,8 µm und 8 µm, und zwischen 8 µm und 80 µm.

6. Erosionsschutzschicht nach Anspruch 3, **dadurch gekennzeichnet, dass** die Hartstoffpartikel (4) einen Durchmesser kleiner als 8 nm haben.

7. Erosionsschutzschicht nach einem der Ansprüche 1 bis 6, **dadurch gekennzeichnet, dass** die Hartstoffpartikel (4) den gleichen Durchmesser haben.

8. Erosionsschutzschicht nach einem der Ansprüche 1 bis 6, **dadurch gekennzeichnet, dass** die Hartstoffpartikel (4) unterschiedliche Durchmesser haben.

9. Erosionsschutzschicht nach einem der Ansprüche 1 bis 8, **dadurch gekennzeichnet, dass** die Hartstoffpartikel (4) aus einem oder mehreren der Materialien enthaltend Keramik, kubisches Bornitrid, Silikate, Carbide oder andere Nitride oder diamantartige Kohlenstoffpartikel bestehen.

10. Erosionsschutzschicht nach einem der Ansprüche 1 bis 9, **dadurch gekennzeichnet, dass** die Bindeschicht (3) metallisch ist.

11. Erosionsschutzschicht nach einem der Ansprüche 1 bis 9, **dadurch gekennzeichnet, dass** die Bindeschicht (3) organisch oder anorganisch ist.

12. Erosionsschutzschicht nach einem der Ansprüche 1 bis 11, **dadurch gekennzeichnet, dass** die Bindeschicht (3) weniger als 40 Vol.% der Erosionsschutzschicht (2) ausmacht.

13. Verfahren zur Herstellung einer der Strömung ausgesetzten Erosionsschutzschicht nach einem oder mehreren der Ansprüche 1 bis 12, **dadurch gekennzeichnet, dass** die Erosionsschutzschicht (2) durch Spritzen einer Mischung eines die Bindeschicht (3) bildenden Materials und der Hartstoffpartikel (4) auf die aerodynamische Komponente oder Struktur (1) derart aufgebracht wird, dass die Vielzahl von Hartstoffpartikeln (4) in der Bindeschicht (3) eingelagert sind; wobei die Bindeschicht (3) weniger als 60 Vol.% der Erosionsschutzschicht (2) ausmacht.

14. Verfahren zur Herstellung einer der Strömung ausgesetzten Erosionsschutzschicht nach einem oder mehreren der Ansprüche 1 bis 12, **dadurch gekennzeichnet, dass** die Erosionsschutzschicht (2) durch Aufdampfen eines die Bindeschicht (3) bildenden Materials auf die aerodynamische Komponente oder Struktur (1) hergestellt wird, wobei die Hartstoffpartikel (4) in eine Dampfwolke des die Bindeschicht (3) bildenden Materials eingebracht und zusammen mit diesem auf die aerodynamische Komponente oder Struktur (1) derart aufgebracht werden, dass die Vielzahl von Hartstoffpartikeln (4) in der Bindeschicht (3) eingelagert sind; wobei die Bindeschicht (3) weniger als 60 Vol.% der Erosionsschutzschicht (2) ausmacht.

15. Verfahren nach Anspruch 13 oder 14, **dadurch gekennzeichnet, dass** die Erosionsschutzschicht (2) in einem Arbeitsgang in einer gewünschten Schichtdicke (d) auf die aerodynamische Komponente oder Struktur (1) aufgetragen wird.

## Claims

1. Anti-erosion layer to provide protection for aerodynamic components or structures against wear by airflow-borne particles, wherein the anti-erosion layer is exposed to the airflow,
**characterized in that** a plurality of hard material particles (4) are embedded in a binding layer (3), consisting of a material that adheres well to the aerodynamic components or structures (1); and
that the binding layer (3) accounts for less than 60% by volume of the anti-erosion layer (2).

2. Anti-erosion layer according to claim 1, **characterized in that** the hard material particles (4) have a diameter in the micrometer range.

3. Anti-erosion layer according to claim 1, **characterized in that** the hard material particles (4) have a diameter in the nanometer range.

4. Anti-erosion layer according to claim 2, **characterized in that** the hard material particles (4) have a diameter of less than 200 µm.

5. Anti-erosion layer according to claim 2, **characterized in that** the hard material particles (4) have a diameter of between 8 nm and 20 µm, in particular between 8 nm and 80 nm, between 80 nm and 800 nm, between 0,8 µm and 8 µm, and between 8 µm and 80 µm.

6. Anti-erosion layer according to claim 3, **characterized in that** the hard material particles (4) have a diameter of less than 8 nm.

7. Anti-erosion layer according to one of the claims 1 to 6, **characterized in that** the hard material particles (4) have the same diameter.

8. Anti-erosion layer according to one of the claims 1 to 6, **characterized in that** the hard material particles (4) have different diameters.

9. Anti-erosion layer according to one of the claims 1 to 8, **characterized in that** the hard material particles (4) are made from one or several of the materials comprising ceramic, cubic boron nitride, silicates, carbides, or other nitrides, or diamond-like carbon particles.

10. Anti-erosion layer according to one of the claims 1 to 9, **characterized in that** the binding layer (3) is metallic.

11. Anti-erosion layer according to one of the claims 1 to 9, **characterized in that** the binding layer (3) is organic or inorganic.

12. Anti-erosion layer according to one of the claims 1 to 11, **characterized in that** the binding layer (3) accounts for less than 40% by volume of the anti-erosion layer (2).

13. Method for producing an anti-erosion layer according to one or more of the claims 1 to 12, which anti-erosion layer is exposed to the airflow, **characterized in that** the anti-erosion layer (2) is applied by spraying a mixture of the material forming the binding layer (3) and the hard material particles (4) onto the aerodynamic component or structure (1) such that the plurality of hard material particles (4) is embedded in the binding layer (3); wherein the binding layer (3) accounts for less than 60% by volume in the anti-erosion layer (2).

14. Method for producing an anti-erosion layer according to one or more of the claims 1 to 12, which anti-erosion layer is exposed to the flow, **characterized in that** the anti-erosion layer (2) is produced by evaporation coating of a material, which is forming the binding layer (3), onto the aerodynamic component or structure (1), wherein the hard material particles (4) are introduced into a cloud of vapour of the material forming the binding layer (3), and together with this material are applied to the aerodynamic component or structure (1) such that the plurality of hard material particles is embedded in the binding layer (3); wherein the binding layer (3) accounts for less than 60% by volume in the anti-erosion layer (2).

15. Method according to claim 13 or 14, **characterized in that** the anti-erosion layer (2) is applied to the aerodynamic component or structure (1) at a desired layer thickness (d) in a single operation.

## Revendications

1. Couche de protection contre l'érosion destinée à la protection contre l'usure par des particules plus lourdes que l'air pour des composants et structures aérodynamiques, la couche de protection contre l'érosion étant exposée à l'écoulement, **caractérisée en ce qu'**une multiplicité de particules de matériaux à résistance mécanique élevée (4) est incluse dans une couche de liant (3) en un matériau de bonne adhérence sur les composants ou structures (1) aérodynamiques ; et
que la couche de liant (3) représente moins de 60% en volume de la couche de protection contre l'érosion (2).

2. Couche de protection contre l'érosion selon la revendication 1, **caractérisée en ce que** les particules de matériaux à résistance mécanique élevée (4) ont un diamètre de l'ordre du micromètre.

3. Couche de protection contre l'érosion selon la revendication 1, **caractérisée en ce que** les particules de matériaux à résistance mécanique élevée (4) ont un diamètre de l'ordre du nanomètre.

4. Couche de protection contre l'érosion selon la revendication 2, **caractérisée en ce que** les particules de matériaux à résistance mécanique élevée (4) ont un diamètre inférieur à 200 µm.

5. Couche de protection contre l'érosion selon la revendication 2, **caractérisée en ce que** les particules de matériaux à résistance mécanique élevée (4) ont un diamètre compris entre 8 nm et 80 µm, en particulier entre 8 nm et 80 nm, entre 80 nm et 800 nm, entre 0,8 µm et 8 µm, et entre 8 µm et 80 µm.

6. Couche de protection contre l'érosion selon la revendication 3, **caractérisée en ce que** les particules de matériaux à résistance mécanique élevée (4) ont un diamètre inférieur à 8 nm.

7. Couche de protection contre l'érosion selon l'une des revendications 1 à 6, **caractérisée en ce que** les particules de matériaux à résistance mécanique élevée (4) ont le même diamètre.

8. Couche de protection contre l'érosion selon l'une des revendications 1 à 6, **caractérisée en ce que** les particules de matériaux à résistance mécanique élevée (4) ont des diamètres différents.

9. Couche de protection contre l'érosion selon l'une des revendications 1 à 8, **caractérisée en ce que** les particules de matériaux à résistance mécanique élevée (4) se composent d'un ou de plusieurs des matériaux renfermant de la céramique, du nitrure de bore cubique, des silicates, des carbures ou d'autres nitrures ou des particules de carbone sous forme de diamant.

10. Couche de protection contre l'érosion selon l'une des revendications 1 à 9, **caractérisée en ce que** la couche de liant (3) est métallique.

11. Couche de protection contre l'érosion selon l'une des revendications 1 à 9, **caractérisée en ce que** la couche de liant (3) est organique ou minérale.

12. Couche de protection contre l'érosion selon l'une des revendications 1 à 11, **caractérisée en ce que** la couche de liant (3) représente moins de 40% en volume de la couche de protection contre l'érosion (2).

13. Procédé de fabrication d'une couche de protection contre l'érosion exposée à l'écoulement selon l'une ou plusieurs des revendications 1 à 12, **caractérisé en ce que** la couche de protection contre l'érosion (2) est appliquée sur le composant ou la structure aérodynamique (1) par pulvérisation d'un mélange d'un matériau formant la couche de liant (3) et des particules de matériaux à résistance mécanique élevée (4), de telle sorte que la multiplicité de particules de matériaux à résistance mécanique élevée (4) est incluse dans la couche de liant (3) ; la couche de liant (3) représentant moins de 60% en volume de la couche de protection contre l'érosion (2).

14. Procédé de fabrication d'une couche de protection contre l'érosion exposée à l'écoulement selon l'une ou plusieurs des revendications 1 à 12, **caractérisé en ce que** la couche de protection contre l'érosion (2) est produite par métallisation sous vide d'un matériau, formant la couche de liant (3), sur le composant ou structure aérodynamique (1), les particules de matériaux à résistance mécanique élevée (4) étant introduites dans un nuage de vapeur du matériau formant la couche de liant (3) et appliquées avec ce dernier sur le composant ou la structure aérodynamique (1), de telle sorte que la multiplicité de particules de matériaux à résistance mécanique élevée (4) est incluse dans la couche de liant (3) ; la couche de liant (3) représentant moins de 60% en volume de la couche de protection contre l'érosion (2).

15. Procédé selon l'une des revendications 13 et 14, **caractérisé en ce que** la couche de protection contre l'érosion (2) est appliquée en une opération, en une épaisseur de couche souhaitée (d), sur le composant ou la structure aérodynamique (1).
